Europäisches Patentamt

European Patent Office

Office européen des brevets

(19)

(11) Numéro de publication: **0 353 156**
**A1**

(12)

# DEMANDE DE BREVET EUROPEEN

(21) Numéro de dépôt: 89402137.7

(22) Date de dépôt: 27.07.89

(51) Int. Cl.⁵: **G 01 R 31/02**

(30) Priorité: 28.07.88 FR 8810351

(43) Date de publication de la demande:
**31.01.90 Bulletin 90/05**

(84) Etats contractants désignés:
**BE DE ES GB IT NL SE**

(71) Demandeur: **TELEMECANIQUE**
**43-45, Boulevard Franklin Roosevelt**
**F-92500 Rueil Malmaison (FR)**

(72) Inventeur: **Dano, Maurice**
**37, Chemin de Villebois**
**F-38100 Grenoble (FR)**

**Sithimolada, Inthalongseng**
**5, rue de la Liberté**
**F-38130 Echirolles (FR)**

(74) Mandataire: **Marquer, Francis et al**
**Cabinet Moutard 35, Avenue Victor Hugo**
**F-78960 Voisins le Bretonneux (FR)**

(54) **Circuit d'entrée, du type tout ou rien, d'un automate programmable.**

(57) Un circuit d'entrée tout ou rien (10) permet de détecter l'état d'un capteur (12) auquel il est connecté ainsi que les défauts du système d'entrée par comparaison de la tension d'entrée (Ve) à des seuils asservis à la tension d'alimentation (Va). Dans un circuit d'entrée à microprocesseur (24) ceci peut être réalisé par comparaison à des seuils numériques fixes de la tension d'entrée (Ve) convertie en numérique au moyen d'un convertisseur analogique-numérique (28) dont la tension de référence (Vref) est asservie à la tension d'alimentation.

FIG.1

EP 0 353 156 A1

Description

## CIRCUIT D'ENTREE, DU TYPE TOUT OU RIEN, D'UN AUTOMATE PROGRAMMABLE

L'invention concerne un circuit d'entrée d'un automate programmable, destiné à être connecté à au moins un capteur de type tout ou rien, le capteur comportant en parallèle une résistance et un élément de commutation qui peut prendre l'état ouvert ou fermé et étant disposé entre une borne d'alimentation et une borne de sortie, ledit circuit d'entrée comportant deux bornes d'alimentation entre lesquelles est appliquée une tension d'alimentation, l'une de ces bornes étant destinée à être connectée à une borne d'alimentation du capteur, et une borne d'entrée destinée à être connectée à la borne de sortie du capteur, le circuit d'entrée comportant des moyens de comparaison des signaux d'entrée appliqués sur sa borne d'entrée à un seuil, lesdits moyens fournissant en sortie des signaux représentatifs de l'état de l'élément de commutation du capteur.

On sait que, dans les automates programmables, un système d'entrée/sortie assure l'interfaçage entre l'unité centrale de traitement et des dispositifs d'entrée, capteurs ou détecteurs d'une part, et les actionneurs du processus d'autre part.

Les circuits d'entrée du type tout ou rien comparent le signal d'entrée à un seuil de reconnaissance de manière à déterminer l'état du dispositif d'entrée auquel il est connecté, des entrées d'un même type se différenciant les unes des autres par la nature (continue ou alternative) et la valeur des tensions d'alimentation des capteurs.

On a, par ailleurs, déjà proposé (FR-A-2 565 378) certaines configurations de circuits d'entrée/sortie permettant la détection d'un certain nombre de défauts dus au système d'entrée/sortie. Ces systèmes sont complexes et permettent essentiellement la détection de défauts liés à un circuit de sortie.

L'invention concerne plus spécifiquement les circuits d'entrée tout ou rien et a pour but un circuit standardisé fiable permettant à la fois la détection de l'état du capteur et la détection de défauts liés au système d'entrée, quelle que soit la valeur de la tension d'alimentation.

Selon l'invention, dans un circuit d'entrée du type précité, les moyens de comparaison comportent un microprocesseur et un convertisseur analogique-numérique, dont une entrée est connectée à la borne d'entrée du circuit d'entrée et dont la sortie est connectée à une entrée du microprocesseur, les signaux numériques de sortie du convertisseur étant comparés dans le microprocesseur à des seuils numériques préétablis d'état du capteur et de coupure de ligne, et des moyens d'asservissement sont prévus pour générer une tension de référence proportionnelle à la tension d'alimentation, la tension de référence étant appliquée sur une entrée de référence du convertisseur.

Dans ce type de circuit d'entrée intelligent, les signaux analogiques d'entrée sont donc numérisés au moyen d'un convertisseur analogique-numérique dont la tension de référence est asservie à la tension d'alimentation, puis comparés au moyen du microprocesseur à des seuils numériques préétablis.

Le capteur comportant une résistance en parallèle sur son élément de commutation, le circuit d'entrée peut donc détecter une coupure de ligne telle qu'un défaut de fil coupé. Si le capteur comporte de plus une résistance en série avec l'élément de commutation, il est possible, en ajoutant un seuil de comparaison supplémentaire asservi à la tension d'alimentation et consultable par le microprocesseur, de détecter également un court-circuit.

D'autres avantages et caractéristiques ressortiront plus clairement de l'exposé qui va suivre d'un mode particulier de réalisation de l'invention, donné à titre d'exemple non limitatif et représenté aux dessins annexés sur lesquels :

La figure 1 représente un mode de réalisation d'un circuit d'entrée selon l'invention ;

La figure 2 illustre les valeurs prises par la tension d'entrée Vc du convertisseur analogique-numérique en fonction des différents états du capteur et les seuils de comparaison numériques correspondants du circuit selon la figure 1 ;

La figure 3 représente un circuit d'entrée selon l'invention à voies d'entrée multiplexées.

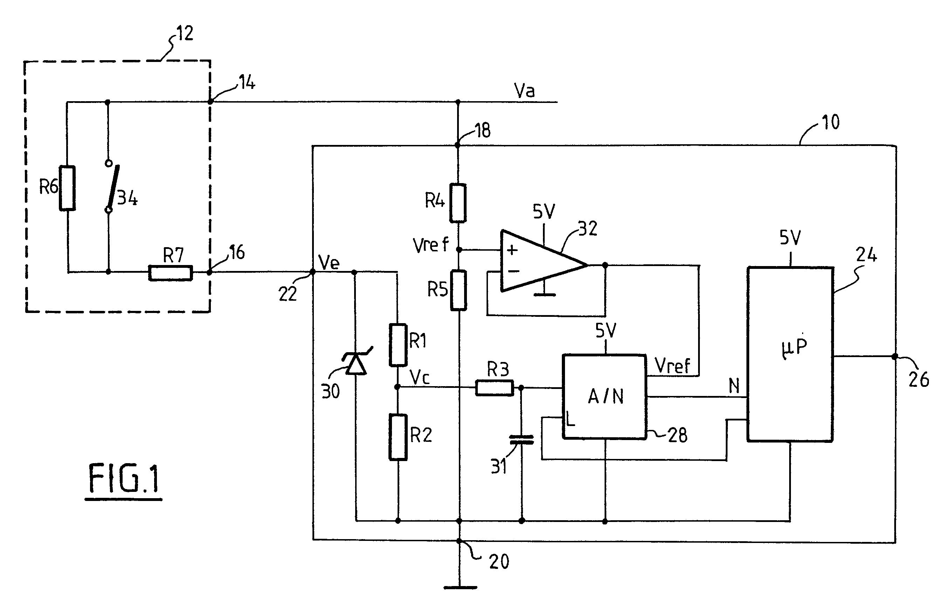

Le circuit d'entrée 10 représenté sur la figure 1 est connecté à un capteur 12, de type tout ou rien, comportant une borne d'alimentation 14 et une borne 16 de sortie du signal. La borne 14 d'alimentation du capteur et une borne 18 d'alimentation du circuit d'entrée sont toutes deux connectées à une tension d'alimentation Va, tandis qu'une seconde borne, 20, d'alimentation du circuit d'entrée est connectée à la masse. A titre d'exemple non limitatif, cette tension peut être une tension continue pouvant varier entre 20 et 60 V. Le circuit d'entrée 10 comporte une borne d'entrée 22 connectée à la borne 16 de sortie du signal du capteur.

Dans le mode de réalisation représenté sur la figure 1, le circuit d'entrée 10, du type intelligent, comporte un microprocesseur 24 destiné au traitement des informations qui lui sont fournies par le capteur 12, ce microprocesseur communiquant, de manière connue, par l'intermédiaire d'une borne de sortie 26 avec l'unité centrale de l'automate programmable.

Le signal Ve appliqué sur la borne d'entrée 22 du circuit d'entrée 10 est, après mise en forme, converti en un signal numérique N dans un convertisseur analogique-numérique 28. Ce signal numérique N est ensuite appliqué au microprocesseur 24. Le microprocesseur 24, le convertisseur 28 et tous les autres circuits logiques du circuit d'entrée 10 sont alimentés par une tension de 5 V produite par une source de tension auxiliaire, externe, non représentée pour ne pas surcharger inutilement la figure. La tension d'entrée Ve doit donc être mise en forme avant d'être appliquée à l'entrée du convertisseur 28 de manière à être adaptée aux tensions acceptables par celui-ci. Pour cela, la tension Ve est appliquée aux bornes d'un diviseur résistif constitué par deux résistances R1 et R2 en série entre les bornes 22 et 20. Les valeurs respectives des résistances R1 et R2 doivent être telles que la tension calibrée Vc aux bornes de la résistance R2 soit inférieure ou égale à 5 V lorsque la tension d'entrée Ve est maximale. A titre d'exemple, on peut choisir R1 = 1,8 Kohms et R2 = 120 ohms, ce qui correspond à une tension d'entrée Ve de 80 V pour une tension calibrée Vc de 5 V.

Une diode Zener 30, ou tout autre élément écrêteur équivalent, est de préférence disposé en parallèle sur le pont diviseur entre les bornes 20 et 22, de manière à protéger le circuit d'entrée contre les surtensions supérieures à la tension maximale admissible (5 V pour Vc).

De manière classique, une résistance de limitation R3 est disposée entre le point milieu du diviseur de tension et l'entrée du convertisseur, une capacité 31 étant connectée entre cette entrée et la masse pour former un filtre passe-bas.

Selon l'invention, un signal de référence Vref, asservi à la tension d'alimentation Va, est appliqué à l'entrée de référence du convertisseur analogique-numérique 28. Dans le mode de réalisation préféré représenté sur la figure 1, le signal de référence Vref est obtenu à l'aide d'un pont diviseur résistif constitué par deux résistances R4 et R5 en série entre les bornes d'alimentation 18 et 20. Un amplificateur opérationnel 32 monté en adaptateur d'impédance peut, si nécessaire, être connecté entre le point milieu du pont diviseur et l'entrée de référence du convertisseur 28.

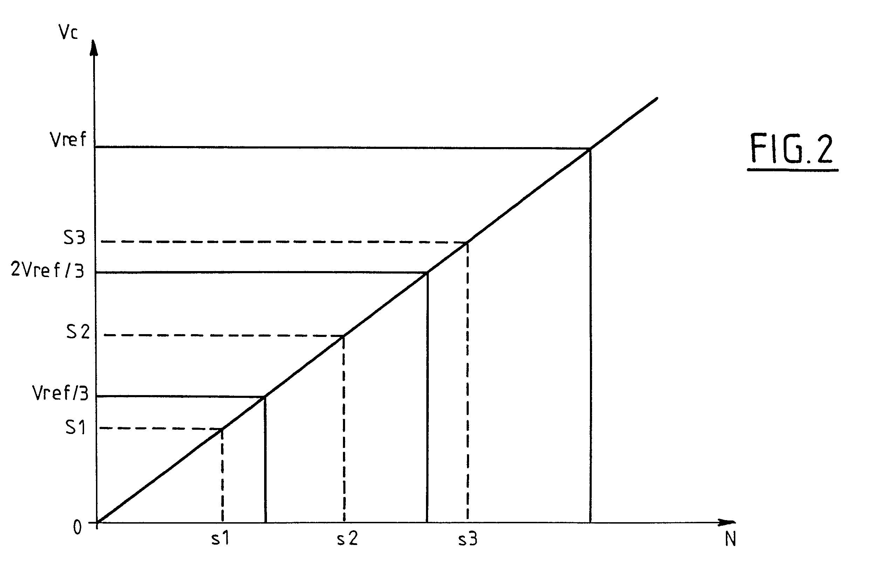

Sous la commande du microprocesseur, qui applique un signal sur son entrée L, le convertisseur 28 convertit le signal calibré Vc en un signal numérique N dont la valeur numérique la plus élevée correspond à un signal calibré Vc = Vref. Ainsi, pour un convertisseur à 8 bits, tous les bits seront à 1 lorsque le signal calibré est égal à Vref. On aura toujours la même résolution, complète, pour toutes les valeurs de la tension calibrée comprises entre O et Vref, quelle que soit la valeur de la tension de référence, ainsi que cela ressort clairement de la figure 2.

Les valeurs des résistances R4 et R5 sont choisies de manière à ce que la valeur de la tension de référence soit maximale, soit 5 V, lorsque la tension d'alimentation est maximale. A titre d'exemple, on peut choisir R4 = 18 Kohms et R5 = 1,2 Kohms, ce qui correspond à une tension de référence Vref de 5 V pour une tension d'alimentation Va de 80 V.

La tension d'entrée Ve pouvant au maximum être égale à la tension d'alimentation Va, et les tensions calibrées et de référence Vc et Vref devant être égales au maximum à 5 V, il est préférable de choisir les valeurs des résistances R1 à R4 de manière à ce que le coefficient k de proportionnalité entre Va et Vref soit identique à celui entre Ve et Vc, soit Va = k Vref et Ve = k Vc.

Le signal numérique N de sortie du convertisseur est comparé dans le microprocesseur à un certain nombre de seuils numériques s1, s2, s3 (figure 2), préétablis de tout manière convenable et permettant ainsi de déterminer l'état du capteur et de détecter un certain nombre de défauts.

Si l'on se réfère à la figure 1, le capteur 12 est constitué par un élément de commutation 34, disposé entre les bornes 14 et 16, et pouvant être ouvert ou fermé. Les circuits d'entrée classiques détectent l'état d'un capteur tout ou rien en comparant sa tension de sortie, qui passe de 0 à l'état ouvert, à la tension d'alimentation à l'état fermé, à un seuil qui est généralement égal à 70 % de la tension d'alimentation.

Le circuit d'entrée selon l'invention permet non seulement de déterminer l'état du capteur, mais également de détecter certains défauts. Pour cela, il est utilisé avec un capteur comportant une résistance R6 en parallèle sur l'élément de commutation. Ainsi, en position d'ouverture du capteur, la tension d'entrée Ve du circuit d'entrée n'est pas nulle, un courant de fuite parcourant la résistance R6. Par contre, si l'un des conducteurs ou fils de liaison est coupé, soit en amont de la borne 14, soit entre les bornes 16 et 22, la tension d'entrée Ve passe à zéro. Dans certains types de capteurs, il n'est pas nécessaire d'ajouter une résistance R6 en parallèle sur l'élément de commutation, celui-ci comportant une résistance de fuite suffisante pour jouer le rôle de la résistance R6.

Dans un mode de réalisation préféré, une résistance R7 est introduite dans le capteur en série avec l'élément de commutation, de manière à permettre également la détection d'un court-circuit entre la ligne d'alimentation connectée à la borne 14 et le fil de liaison entre les bornes 16 et 22. En effet, en cas de court-circuit, la tension d'entrée Ve est alors égale à la tension d'alimentation, alors qu'en position de fermeture du capteur, une chute de tension dans la résistance R7 diminue la tension d'entrée.

A titre d'exemple, on a représenté sur la figure 2, en trait plein, les valeurs de la tension calibrée Vc correspondant aux deux états possibles du capteur et aux deux défauts détectables avec le circuit d'entrée représenté sur la figure 1, en donnant aux diverses résistances les valeurs suivantes :

R1 = 1,8 Kohms
R2 = 120 ohms
R4 = 18 Kohms
R5 = 1,2 Kohms
R6 = 3,3 Kohms
R7 = 1 Kohms

On obtient ainsi :

Vc = Vref en cas de court-circuit
Vc = 2Vref/3 en position de fermeture du capteur
Vc = Vref/3 en position d'ouverture du capteur
Vc = 0 en cas de fil coupé.

La comparaison de la tension d'entrée Ve, après calibrage, à 3 seuils préétablis permet ainsi de distinguer ces quatre états. A titre d'exemple, on a indiqué sur la figure 2 les seuils S1, S2 et S3 pouvant être choisis pour distinguer ces 4 états :

S1 = Vref/4
S2 = Vref/2
S3 = 3Vref/4

Plus généralement, on a :

Va = k Vref

Vref = k1 S1
Vref = k2 S2
Vref = k3 S3
soit Va = kk1S1 = kk2S2 = kk3S3. Les seuils S1 à S3 sont donc bien asservis à la tension d'alimentation.

A ces trois seuils correspondent (figure 2) trois valeurs numériques s1, s2 et s3 qui sont fixes et totalement indépendantes de la tension d'alimentation. Ainsi, grâce à l'utilisation par le convertisseur A/N d'une tension de référence asservie à la tension d'alimentation, il est possible d'utiliser dans le microprocesseur des seuils numériques fixes pour comparer la tension d'entrée à des seuils (S1 à S3) asservis à la tension d'alimentation.

Il est évident que l'on peut utiliser un microcesseur pour plusieurs points d'entrée. Dans ce cas, on utilisera de préférence un seul convertisseur analogique-numérique dont l'entrée sera connectée par l'intermédiaire d'un multiplexeur aux points milieu de plusieurs ponts diviseurs résistifs, eux-mêmes connectés chacun à un capteur.

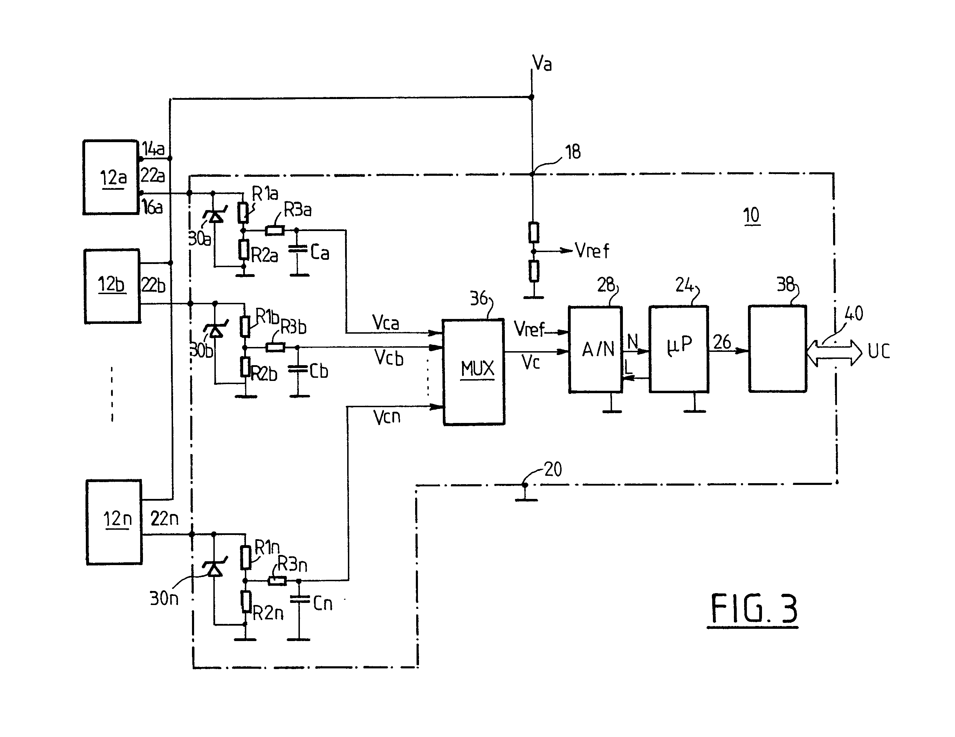

La figure 3 illustre un circuit d'entrée à voies d'entrée multiplexées. Plusieurs capteurs 12a, 12b, ...12n sont connectés à des entrées respectives 22a, 22b, ...22n du circuit d'entrée. Chaque signal d'entrée Ve, écrêté par un élément 30, divisé par un pont R1, R2 et filtré par un élément R3, C, donne ainsi un signal Vca, Vcb, ...Vcn appliqué à l'une des entrées parallèles d'un multiplexeur 36, le signal Vc de sortie du multiplexeur étant appliqué à l'entrée analogique du convertisseur A/N 28. La borne de sortie 26 du microprocesseur est reliée à l'entrée d'un moyen démultiplexeur tel qu'un registre 38 figeable ; ce registre est accouplable au bus 40 de liaison avec l'unité centrale UC de l'automate, de manière asynchrone par rapport aux cycles de conversion et comparaison. Le multiplexeur 36 et le registre 38 sont gérés par des signaux appropriés. Les éléments de filtrage R3, C sont prévus de préférence pour chaque voie en amont du multiplexeur, plutôt qu'entre celui-ci et le convertisseur A/N 28, pour privilégier la rapidité d'acquisition des données.

La description a été faite pour une tension d'alimentation continue. Il est néanmoins clair que l'invention est également applicable dans le cas où la tension d'alimentation est alternative, des redresseurs à double alternance étant alors disposés entre les bornes d'alimentation et d'entrée et les ponts diviseurs résistifs qui leur sont associés.

Le capteur peut également être constitué par un capteur électronique à 3 bornes, la troisième borne étant alors connectée à la masse.

## Revendications

1. Circuit d'entrée d'un automate programmable, destiné à être connecté à au moins un capteur (12), de type tout ou rien, comportant en parallèle une résistance et un élément de commutation (34) qui peut prendre l'état ouvert ou fermé, le capteur étant disposé entre une borne d'alimentation (14) et une borne de sortie (16), ledit circuit d'entrée comportant deux bornes d'alimentation (18, 20) entre lesquelles est appliquée une tension d'alimentation (Va), l'une de ces bornes étant destinée à être connectée à la borne d'alimentation (14) du capteur, et une borne d'entrée (22) destinée à être connectée à la borne de sortie (16) du capteur, le circuit d'entrée (10) comportant des moyens de comparaison des signaux d'entrée (Ve) appliqués sur sa borne d'entrée (22) à au moins un seuil, ledits moyens fournissant en sortie (26) des signaux représentatifs de l'état de l'élément de commutation du capteur et d'une coupure de ligne,
caractérisé en ce que :
- les moyens de comparaison comportent un microprocesseur (24) et un convertisseur analogique-numérique (28), dont une entrée est connectée à la borne d'entrée (22) du circuit d'entrée et dont la sortie est connectée à une entrée du microprocesseur, les signaux numériques (N) de sortie du convertisseur étant comparés dans le microprocesseur à des seuils numériques préétablis (s1, s2) d'état du capteur et de coupure de ligne,
- des moyens d'asservissement (R4, R5) sont prévus pour produire une tension de référence (Vref) proportionnelle à la tension d'alimentation (Va), la tension de référence étant appliquée sur une entrée de référence du convertisseur.

2. Circuit d'entrée selon la revendication 1, caractérisé en ce que les moyens de production de la tension de référence (Vref) sont constitués par un pont diviseur résistif (R4, R5) connecté entre les bornes d'alimentation (18, 20) du circuit d'entrée, le point milieu du pont diviseur étant connecté à l'entrée de référence du convertisseur.

3. Circuit d'entrée selon l'une des revendications 1 et 2, caractérisé en ce qu'il comporte un pont diviseur résistif (R1, R2) connecté entre la borne d'entrée (22) et la borne d'alimentation (20) qui n'est pas connectée au capteur, le point milieu dudit pont résistif étant connecté à l'entrée des moyens de comparaison.

4. Circuit d'entrée selon l'une quelconque des revendications 1 à 3, caractérisé en ce qu'il est destiné à être connecté à un capteur (12) comportant une résistance (R7) en série avec l'élément de commutation, et en ce qu'il comporte des moyens de comparaison des signaux d'entrée (Ve) à un seuil (S3), asservi à la tension d'alimentation, de manière à détecter un court-circuit.

5. Circuit d'entrée selon l'une quelconque des revendications 1 à 4, caractérisé en ce que les moyens de comparaison comportent un multiplexeur (36) présentant plusieurs bornes d'entrée (22a, 22b, ...22n) connectées aux points milieu de ponts diviseurs (R1a, R1b ; R2a, R2b ; ...R1n, R2n) des capteurs respectifs (12a, 12b, ...12n) et une borne de sortie reliée à l'entrée analogique du convertisseur analogique-numérique (28), tandis que la sortie (26) du microprocesseur (24) est reliée à un moyen démultiplexeur (38) accouplable au bus (40) de l'unité centrale.

FIG.1

EP 0 353 156 A1

FIG.2

EP 0 353 156 A1

FIG. 3

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| X | GB-A-2 155 223 (BL TECHNOLOGY)<br>* Page 1, lignes 5-6; page 1, ligne 61 - page 2, ligne 20; figure 4 *<br>--- | 1-5 | G 01 R 31/02 |
| A | ELECTRONIC ENGINEERING, vol. 55, no. 684, décembre 1983, page 26, Londres, GB; J. BUTTON: "Window detectors and indicators"<br>* En entier *<br>--- | 1 | |
| A | NEW ELECTRONICS, vol. 16, no. 20, 18 octobre 1983, pages 64-69, Londres, GB; C. RYAN et al.: "Ultra-fast A-to-D converters"<br>* Figure 4 *<br>--- | 1 | |
| A | WO-A-8 403 772 (J.G. BIDDLE)<br>--- | | |
| A | US-A-3 886 541 (G.A. WATSON)<br>----- | | |

DOMAINES TECHNIQUES
RECHERCHES (Int. Cl.5)

G 01 R

Le présent rapport a été établi pour toutes les revendications

| Lieu de la recherche | Date d'achèvement de la recherche | Examinateur |
|---|---|---|
| LA HAYE | 22-09-1989 | HOORNAERT W. |